# EUROPÄISCHE PATENTSCHRIFT

(11) **EP 4 315 287 B1**
(45) Veröffentlichungstag und Bekanntmachung des Hinweises auf die Patenterteilung: **04.03.2026**
(21) Anmeldenummer: 22714994.5
(22) Anmeldetag: 22.03.2022
(51) Int. Cl.: G07D 7/04, G01R 33/60, G01R 33/341, G01R 33/30, G01N 24/10

(54) **SENSORELEMENT UND VORRICHTUNG FÜR DIE ECHTHEITSPRÜFUNG EINES DATENTRÄGERS MIT EINEM SPINRESONANZ-MERKMAL**
SENSOR ELEMENT AND DEVICE FOR CHECKING THE AUTHENTICITY OF A DATA CARRIER HAVING A SPIN RESONANCE FEATURE
ÉLÉMENT CAPTEUR ET DISPOSITIF POUR VÉRIFIER L'AUTHENTICITÉ D'UN SUPPORT DE DONNÉES PRÉSENTANT UNE CARACTÉRISTIQUE DE RÉSONANCE DE SPIN

(30) Priorität: 26.03.2021 DE 102021001594
(43) Veröffentlichungstag der Anmeldung: 07.02.2024
(73) Patentinhaber: Giesecke+Devrient Currency Technology GmbH, 81677 München (DE)
(72) Erfinder: HUBER, Stephan, 80634 München (DE); HAPP, Thomas, 81825 München (DE)
(74) Vertreter: Giesecke+Devrient IP
(86) Internationale Anmeldenummer: PCT/EP2022/025116
(87) Internationale Veröffentlichungsnummer: WO 2022/199892

(56) Entgegenhaltungen:
- US-A- 5 149 946
- US-A1- 2005 270 023
- ELLERSIEK DENNIS: "Entwicklung und Charakterisierung von mikrostrukturierten Planarspulen für Kernspinresonanz-Anwendungen", 1 January 2010 (2010-01-01), XP055936872, Retrieved from the Internet <URL:http://publications.rwth-aachen.de/record/51600/files/Ellersiek_Dennis.pdf> [retrieved on 20220629]
- RIZWAN AHMAD ET AL: "Theory, Instrumentation, and Applications of Electron Paramagnetic Resonance Oximetry", CHEMICAL REVIEWS, vol. 110, no. 5, 12 May 2010 (2010-05-12), US, pages 3212 - 3236, XP055441105, ISSN: 0009-2665, DOI: 10.1021/cr900396q

## Beschreibung

Die Erfindung betrifft ein Sensorelement für die Echtheitsprüfung eines flächigen Datenträgers, insbesondere einer Banknote, mit einem Spinresonanz-Merkmal, sowie eine Prüfvorrichtung mit einem solchen Sensorelement.

Datenträger, wie Wert- oder Ausweisdokumente, aber auch andere Wertgegenstände, wie etwa Markenartikel, werden zur Absicherung oft mit Sicherheitselementen versehen, die eine Überprüfung der Echtheit der Datenträger gestatten und die zugleich als Schutz vor unerlaubter Reproduktion dienen. Es ist bekannt, bei der maschinellen Echtheitsprüfung Sicherheitselemente mit Spinresonanz-Merkmalen zur Absicherung von Dokumenten und anderen Datenträgern einzusetzen. Die Sicherheitselemente sind dazu mit Substanzen versehen, die eine Spinresonanz-Signatur aufweisen. Zu den für die Echtheitsprüfung einsetzbaren Spinresonanz-Signaturen gehören insbesondere Kernspin-Resonanz-Effekte (Nuclear Magnetic Resonance, NMR) Elektronspin-Resonanz-Effekte (ESR) und ferromagnetische Resonanz-Effekte (FMR).

Bei der Prüfung von Banknoten werden zur Detektion der Spinresonanz-Signaturen meist drei verschiedene Magnetfelder im Messbereich beispielsweise einer Banknotenbearbeitungsmaschine erzeugt. Dabei handelt es sich konkret um ein quasistatisches Polarisationsfeld B₀, das parallel zur Axialrichtung (z-Richtung) des Luftspalts eines magnetischen Kreises verläuft. Ein zweites Magnetfeld ist durch ein Modulationsfeld B_{mod} gebildet, welches ebenfalls parallel zur z-Achse verläuft und typischerweise eine Frequenz f_{mod} im kHz-Bereich hat. Zur Anregung von Übergängen zwischen den aufgespaltenen Spin-Energieniveaus der Spinresonanz-Signatur-Substanzen ist ein Anregefeld B₁ vorgesehen, das typischerweise Frequenzen oberhalb von 1 GHz aufweist und senkrecht zur B₀-Richtung polarisiert ist.

Zur Erzeugung des Polarisationsfeldes B₀ kommt häufig ein magnetischer Kreis zum Einsatz, der den magnetischen Fluss eines Permanentmagneten oder einer Spule zu dem Luftspalt leitet, in dem die Detektion der Spinresonanz-Signaturen stattfindet. Zur Erzeugung des Modulationsfeldes B_{mod} kommt meist eine einzelne Zylinderspule oder ein Zylinderspulen-Paar in einer Helmholtz-Konfiguration zum Einsatz, also ein Zylinderspulen-Paar in einer Konfiguration, bei der zwei Zylinderspulen mit Spulenradius r parallel zueinander auf derselben Achse in einem Abstand r platziert sind und gleichsinnig vom selben Strom durchflossen werden. Die Zylinderspulen werden oft nahe dem Luftspalt um den magnetischen Kreis gewickelt, können aber auch direkt im Luftspalt angeordnet sein. Für die Erzeugung des Anregefeldes B₁ kommt typischerweise ein Resonator zum Einsatz, der zumeist ebenfalls im Luftspalt angeordnet ist.

Für die Echtheitsprüfung wird ein Prüfling in den Luftspalt des magnetischen Kreises gebracht und auf das Vorliegen einer Spinresonanz-Signatur geprüft. Die gemessene Spinresonanz-Signalstärke steigt sowohl mit der Feldstärke des Polarisationsfeldes B₀, als auch der Feldstärke des Modulationsfeldes B_{mod} an, so dass vorteilhaft beide Feldstärken maximiert werden. Die Feldstärke des Polarisationsfeldes B₀ verhält sich dabei etwa indirekt proportional zur Höhe des Luftspalts, kann also durch eine Verringerung der Bauhöhe des Luftspalts gesteigert werden. Eine Erhöhung der Feldstärke des Modulationsfeldes kann beispielsweise durch die Verwendung von Modulationsspulen mit möglichst vielen Windungen erfolgen.

Aus diesen Anforderungen ergibt sich in der Praxis ein Zielkonflikt: Wird eine Zylinderspule oder ein Zylinderspulen-Paar für die Erzeugung des Modulationsfelds B_{mod} im Luftspalt angeordnet, so steigt mit zunehmender Windungszahl auch die Baugröße der Zylinderspulen. Entsprechend muss entweder die Luftspalthöhe vergrößert oder die maximale Windungszahl der Spule begrenzt werden, so dass entweder die Feldstärke des Polarisationsfeldes B₀ oder die Feldstärke des Modulationsfeldes B_{mod}, und somit in beiden Fällen die Stärke des Spinresonanz-Signals begrenzt ist.

Ordnet man anderseits die Zylinderspulen nicht im Luftspalt an, sondern wickelt sie um den magnetischen Kreis, so induziert das Modulationsfeld B_{mod} dort verstärkt Wirbelströme, die ihrerseits mehrere Nachteile mit sich bringen.

Zum einen hat das durch die Wirbelströme erzeugte Magnetfeld nach der Lenzschen Regel eine seiner Ursache entgegengesetzte Polarität. Die Wirbelströme schwächen daher das Modulationsfeld ab und führen zu einer Signalreduktion. Weiter erfordert der Sensorbetrieb insbesondere bei schnell-laufenden Banknoten-Bearbeitungsmaschinen kurze Messzeiten und damit auch hohe Modulationsfrequenzen. Da die Stärke der Wirbelströme aber mit der Modulationsfrequenz zunimmt, wird ein Sensorbetrieb auf schnellen Maschinen erschwert. Schließlich führt die mit den Wirbelströmen verbundene Energiedissipation im Magnetkern zu einer Temperaturerhöhung und damit zu einem sich verändernden magnetischen Widerstand, der seinerseits zu einem Drift der Flussdichte im Luftspalt und damit letztlich zu einem unerwünschten Drift des Nutzsignals führt.

US 5149946 A betrifft ein Verfahren zur Authentifizierung eines Objekts durch Elektronenspinresonanzspektroskopie. Bei dem Verfahren wird dem Objekt mindestens eine Authentifizierungssubstanz zugesetzt, die einen EPR-Peak aufweist, dessen Breite nicht größer als etwa 1,5 Gauß ist. Die Spektroskopie wird in einem statischen Feld mit einer solchen Amplitude durchgeführt, dass die Substanz eine Resonanzfrequenz im Radiofrequenzbereich aufweist. Die Breite des EPR-Peaks der Substanz wird als Unterscheidungskriterium verwendet. Dem statischen Feld wird vorzugsweise ein niederfrequentes kollineares Modulationsfeld überlagert, dessen Amplitude wesentlich größer ist als die EPR-Breite der Substanz. Unter einem elektromagnetischen Radiofrequenzfeld, das senkrecht zum statischen Feld und zum Modulationsfeld verläuft und eine Amplitude aufweist, die nicht kleiner ist als die Peak-Breite, werden paramagnetische Materialien mit einer Peak-Breite, die größer ist als die der authentifizierenden Substanz, nicht erkannt. Offenbart ist außerdem eine Vorrichtung zur Durchführung des Verfahrens sowie ein mit dem Verfahren verwendbares Sicherheitspapier.

Ausgehend davon liegt der Erfindung die Aufgabe zugrunde, eine verbesserte Vorrichtung für die Echtheitsprüfung von Datenträgern mit Spinresonanz-Merkmalen anzugeben, welche insbesondere eine hohe Nutzsignalstärke ermöglicht und auch die Prüfung schnell-bewegter Datenträger erlaubt.

Diese Aufgabe wird durch die Merkmale der unabhängigen Ansprüche gelöst. Weiterbildungen der Erfindung sind Gegenstand der abhängigen Ansprüche.

Die Erfindung stellt ein Sensorelement für die Prüfung, insbesondere Echtheitsprüfung, eines flächigen Datenträgers mit einem Spinresonanz-Merkmal bereit. Bei dem flächigen Datenträger kann es sich beispielsweise um eine Banknote handeln. Das Sensorelement enthält einen Magnetkern mit einem Luftspalt, in den der flächige Datenträger zur Echtheitsprüfung einbringbar ist. Der Luftspalt definiert eine sich zwischen den angrenzenden Flächen des Magnetkerns erstreckende Axialrichtung.

Das Sensorelement enthält weiter eine Polarisationseinrichtung zu Erzeugung eines statischen magnetischen Flusses in dem Luftspalt, eine Modulationseinrichtung zur Erzeugung eines zeitlich variierenden magnetischen Modulationsfelds in dem Luftspalt, und einen Resonator zur Anregung des Spinresonanz-Merkmals des zu prüfenden Datenträgers.

Der Resonator ist insbesondere auch zur Erfassung von Spinresonanz-Signalen des Spinresonanz-Merkmals ausgebildet. Der Resonator kann weiterhin ein Antwortsignal des Spinresonanz-Merkmals aufnehmen und an einen Detektor ausgeben.

Die Spinresonanzen können beispielsweise mit einem Dauerstrich (CW)-Verfahren, einem gepulsten Verfahren oder einem Rapid-Scan-Verfahren bestimmt werden.

Als Besonderheit ist bei dem Sensorelement vorgesehen, dass die Modulationseinrichtung durch zumindest eine in dem Luftspalt angeordnete Planarspule gebildet ist, die in einer Ebene eine oder mehrere Windungen um die Axialrichtung des Luftspalts aufweist.

Mit der erfindungsgemäßen Ausbildung der Modulationseinrichtung lassen sich die oben geschilderten Probleme überwinden. Eine Planarspule genügend hoher Windungszahl kann ohne Weiteres direkt in dem Luftspalt des Magnetkerns angeordnet werden, da Planarspulen eine wesentliche geringere Baugröße, insbesondere in axialer Richtung, als vergleichbare Zylinderspulen aufweisen. Aufgrund der Positionierung der zumindest einen Planarspule im Luftspalt wird eine Induktion von Wirbelströmen im Magnetkern unterdrückt oder weitgehend vermieden. Schließlich ist das von einer Planarspule erzeugte Modulationsfeld aufgrund seiner Geometrie für die Banknotenprüfung sehr gut zugänglich, während bei einer einzelnen Zylinderspule der Bereich des stärksten Felds innerhalb des von den Windungen umschlossenen Spulenkörpers liegt, welcher bei einer automatisierten Messung für einen Banknotenprüfling nicht zugänglich ist.

Die genannte Ebene mit der einen oder den mehreren Windungen steht vorteilhaft senkrecht auf der Axialrichtung des Luftspalts. Dadurch wird das Modulationsfeld vorteilhafterweise parallel zum Polarisationsfeld ausgerichtet.

In einer bevorzugten Gestaltung weist die zumindest eine Planarspule eine spiralförmige Leiterbahnführung mit einem minimalen Innenradius und einem maximalen Außenradius auf. Die Außenkontur der Leiterbahnführung der zumindest einen Planarspule ist vorteilhaft kreisförmig, elliptisch, rechteckig oder polygonal.

Der Leiterbahnabstand aufeinanderfolgender Windungen der zumindest einen Planarspule ist in einer vorteilhaften Gestaltung konstant und ermöglicht so eine besonders einfache Auslegung der Spule. In einer alternativen, ebenfalls vorteilhaften Ausgestaltung variiert der Leiterbahnabstand aufeinanderfolgender Windungen, er kann insbesondere streng monoton zunehmen oder streng monoton abnehmen. Die Variation des Leiterbahnabstands wird vorteilhaft so gewählt, dass die von der Planarspule erzeugte Feldverteilung im Luftspalt, insbesondere an einer Messposition im Luftspalt, besonders homogen ist.

Die Windungszahl der zumindest einen Planarspule liegt vorteilhaft zwischen 2 und 100 (je einschließlich), bevorzugt zwischen 10 und 30 (je einschließlich). Mit einer Windungszahl in diesem Bereich können bei typischen Leiterbahnabmessungen sowohl die Stärke als auch die Verteilung des Modulationsfelds im Luftspalt optimiert werden.

Die Modulationseinrichtung enthält in einer vorteilhaften einfachen Gestaltung nur eine einzige Planarspule, es können allerdings auch mehrere Planarspulen in der Modulationseinrichtung vorgesehen sein, beispielsweise können mehrere Planarspulen gestapelt sein, um die Stärke des erzeugten Modulationsfelds zu erhöhen. Enthält die Modulationseinrichtung mehr als eine Planarspule, so sind diese Planarspulen gemäß einer vorteilhaften Gestaltung identisch ausgebildet, weisen also insbesondere dieselbe Geometrie und Windungszahl auf.

In einer vorteilhaften Weiterbildung der Erfindung enthält die Modulationseinrichtung zwei Planarspulen, die axial beabstandet an der Oberseite bzw. Unterseite des Luftspalts angeordnet sind. Die beiden genannten Planarspulen sind dabei so angeordnet und aufeinander abgestimmt, dass sie zwischen sich einen homogenen Feldverlauf des Modulationsfelds erzeugen. Vorzugsweise ist hierzu vorgesehen, dass die beiden genannten Planarspulen jeweils mit einer Leiterbahnführung mit gleichem minimalen Innenradius und gleichem maximalen Außenradius ausgebildet sind und in axialer Richtung einen Abstand aufweisen, der vorzugsweise mit +/- 10% oder im Wesentlichen dem doppelten Innenradius jeder Spule entspricht. Sie werden bevorzugt in gleicher Richtung von einem Strom gleicher Stärke durchflossen.

Die zumindest eine Planarspule ist zweckmäßig auf einem Spulenträger, insbesondere einer Leiterplatte, ausgebildet. Letzteres ermöglicht eine gut reproduzierbare und kostengünstige Fertigung der Spulen. Ist der Resonator nach einer vorteilhaften Ausgestaltung ebenfalls auf einer Leiterplatte ausgebildet, beispielsweise in Form eines Streifenleitungs-Resonators, so kann der Resonator mit Vorteil zusammen mit der zumindest einen Planarspule auf unterschiedlichen Leiterplattenebenen desselben Bauelements angeordnet werden, so dass eine besonders einfache und kompakte Bauform erhalten wird.

In einer anderen, ebenfalls vorteilhaften Ausgestaltung ist die zumindest eine Planarspule auf einem ferromagnetischen Träger ausbildet, beispielsweise in Form einer Leiterbahn auf einer elektrischen Isolationsschicht, beispielsweise einer Oxidschicht oder einer Polymerschicht, auf einem Weicheisen-Plättchen oder auf einem Ferrit- oder Pulverkern. Die Spule kann auch durch einen Lackdraht auf Eisen oder einem Ferritsubstrat oder Pulverkern gebildet sein. Dabei ist die Planarspule gegenüber dem ferromagnetischen Träger vorzugsweise elektrisch isoliert. Die Verwendung eines ferromagnetischen Trägers erlaubt wegen der erhöhten magnetischen Flussdichte eine weitere Reduktion der Luftspalthöhe.

Die zumindest eine Planarspule ist in einer vorteilhaften Ausgestaltung mit einer Kapazität beschaltet, und bildet zusammen mit dieser einen resonanten Schwingkreis. Damit verbunden steigt der durch die Planarspule fließende Strom und damit auch die Stärke des Modulationsfelds, so dass bei der Echtheitsprüfung ein größeres Spinresonanz-Signal erhalten werden kann. Wie oben erläutert, kann das Modulationsfeld auch durch die Verwendung mehrerer gestapelter Planarspulen in der Modulationseinrichtung erhöht werden. Hierbei hat sich besonders bewährt, dass die Modulationseinrichtung zumindest eine Doppel-Planarspule aufweist, bei der auf der Ober- und Unterseite eines Spulenträgers koaxial jeweils die Windungen einer Planarspule angeordnet sind.

Das Element zur Erzeugung eines statischen magnetischen Flusses ist vorteilhaft durch einen Permanentmagneten gebildet. Dies reduziert gegenüber einem Aufbau, bei dem auch der statische Anteil des magnetischen Flusses durch einen Elektromagneten erzeugt wird, den Energieverbrauch und die Abwärme. Es kann in anderen Gestaltungen allerdings auch vorteilhaft sein, nicht nur den zeitveränderlichen Anteil, sondern auch den statischen Anteil des magnetischen Flusses im Luftspalt mittels Elektromagneten zu erzeugen. Dies ermöglicht nach dem Abschalten des Sensorelements eine besonders einfache Handhabung, insbesondere bei Aufbau, Zerlegung und Transport der Prüfvorrichtung.

Der Resonator ist mit Vorteil im Luftspalt des Magnetkerns angeordnet. Vorteilhaft kommt dabei ein planarer Oberflächen-Resonator, insbesondere ein Streifenleitungsresonator, zum Einsatz.

Das Sensorelement weist mit Vorteil weiter eine Rampspule zur Erzeugung eines gegenüber dem Modulationsfeld langsam zeitlich variierenden Magnetfelds in dem Luftspalt auf. Die Rampspule ist vorzugsweise um den Magnetkern gewickelt. Die Rampspule dient insbesondere der Erzeugung einer Rampenfunktion des Polarisationsfelds und/oder der Kompensation eventueller Drifts der Stärke des Polarisationsfelds.

Die genannte Modulationsspule ist vorzugsweise auf die Erzeugung eines mit einer Frequenz zwischen etwa 1 kHz und etwa 1 MHz variierenden Magnetfelds in dem Luftspalt ausgelegt. Die genannte Rampspule ist vorzugsweise auf die Erzeugung eines mit einer Frequenz unterhalb von etwa 1 kHz variierenden Magnetfelds in dem Luftspalt ausgelegt. Der Resonator ist vorzugsweise auf die Anregung und Erfassung von Spinresonanz-Signalen mit einer Frequenz zwischen etwa 1 MHz und 100 GHz ausgelegt.

Bei dem Spinresonanz-Merkmal des zu prüfenden Datenträgers handelt es sich vorteilhaft um ein Kernspin-Resonanz-Merkmal, ein Elektronspin-Resonanz-Merkmal oder ein ferromagnetisches bzw. ferrimagnetisches Resonanz-Merkmal.

Im Falle von Kernspin-Resonanz-Merkmalen ist der Resonator dabei vorzugsweise in einem Frequenzbereich zwischen 1 MHz und 70 MHz resonant. Besonders bevorzugt ist ein Frequenzbereich zwischen 2 MHz bis 50 MHz.

Im Falle von Elektronspin-Resonanz-Merkmalen oder ferromagnetischen bzw. ferrimagnetischen Resonanz-Merkmalen ist der Resonator dabei vorzugsweise in einem Frequenzbereich zwischen 1 GHz und 100 GHz resonant. Besonders bevorzugt ist ein Frequenzbereich zwischen 5 GHz bis 85 GHz, insbesondere zwischen 15 GHz bis 50 GHz.

Die Erfindung umfasst weiter eine Prüfvorrichtung für die Prüfung, insbesondere Echtheitsprüfung, flächiger Datenträger, insbesondere von Banknoten, mit einem Sensorelement der beschriebenen Art. Die Prüfvorrichtung weist weiter eine Transporteinrichtung auf, die die zu prüfenden flächigen Datenträger entlang eines Transportpfades in den Luftspalt des Magnetkerns einbringt bzw. durch den Luftspalt des Magnetkerns hindurchführt. Die Prüfvorrichtung kann insbesondere Teil einer Banknotenbearbeitungsmaschine sein.

Die Erfindung enthält schließlich auch ein Verfahren zur Prüfung eines flächigen Datenträgers mit einem Spinresonanz-Merkmal, wobei die Prüfung mittels eines Sensorelements der oben beschrieben Art durchgeführt wird. Der zu prüfende flächige Datenträger kann beispielsweise eine Banknote sein. Bei dem Verfahren wird ein zu prüfender flächiger Datenträger in den Luftspalt des Magnetkerns des genannten Sensorelements eingebracht und mit der Polarisationseinrichtung ein statischer magnetischer Fluss in dem Luftspalt erzeugt. Mit der Modulationseinrichtung wird ein zeitlich variierendes magnetisches Modulationsfeld in dem Luftspalt erzeugt, wobei als Modulationseinrichtung eine Einrichtung vorgesehen wird, die durch zumindest eine in dem Luftspalt angeordnete Planarspule gebildet ist, die in einer Ebene eine oder mehrere Windungen um die Axialrichtung des Luftspalts aufweist. Weiter wird mit dem Resonator das Spinresonanz-Merkmal des zu prüfenden Datenträgers angeregt.

Bei einer vorteilhaften Verfahrensführung wird mit dem Resonator auch ein durch die Anregung erzeugtes Antwortsignal des Spinresonanz-Merkmals aufgenommen und an einen Detektor ausgegeben. Grundsätzlich kann ein Antwortsignal des Spinresonanz-Merkmals aber auch mit einer separaten Erfassungseinrichtung aufgenommen werden.

Die Anregung des Spinresonanz-Merkmals und/oder die Aufnahme des Antwortsignals des Spinresonanz-Merkmals erfolgt mit Vorteil in einem Dauerstrich (CW)-Verfahren, in einem gepulsten Verfahren, oder in einem Rapid-Scan-Verfahren.

Bei der Prüfung von flächigen Datenträgern mit einem Kernspin-Resonanz-Merkmal erfolgt die Anregung durch den Resonator vorzugsweise in einem Frequenzbereich zwischen 1 MHz und 70 MHz, insbesondere zwischen 2 MHz und 50 MHz. Bei der Prüfung von flächigen Datenträgern mit einem Elektronspin-Resonanz-Merkmal oder einem ferromagnetischen bzw. ferrimagnetischen Resonanz-Merkmal erfolgt die Anregung durch den Resonator vorzugsweise in einem Frequenzbereich zwischen 1 GHz und 100 GHz, bevorzugt zwischen 5 GHz und 85 GHz, besonders bevorzugt zwischen 15 GHz und 50 GHz.

Die Bewertung des Prüfungsergebnisses erfolgt in der Regel durch einen Vergleich des aufgenommenen Antwortsignals mit einem für das Spinresonanz-Merkmal erwarteten Antwortsignal. Wird innerhalb eines gewissen Toleranzbereichs das erwartete Antwortsignal aufgenommen, so kann auf das Vorliegen des korrekten Spinresonanz-Merkmals und damit beispielsweise auf die Echtheit des Datenträgers geschlossen werden.

Weitere Ausführungsbeispiele sowie Vorteile der Erfindung werden nachfolgend anhand der Figuren erläutert, bei deren Darstellung auf eine maßstabs- und proportionsgetreue Wiedergabe verzichtet wurde, um die Anschaulichkeit zu erhöhen.

Es zeigen:
- Fig. 1: schematisch eine Prüfvorrichtung mit einem zugeführten Banknotenprüfling,
- Fig. 2: die in dem Sensorelement der Fig. 1 eingesetzte Planarspule, in (a) in Aufsicht und in (b) im Querschnitt,
- Fig. 3: in (a) bis (d) einige vorteilhafte Ausführungsformen erfindungsgemäßer Planarspulen,
- Fig. 4: ein Sensorelement nach einem anderen Ausführungsbeispiel der Erfindung mit einem Planarspulen-Paar im Luftspalt,
- Fig. 5: den analytisch berechneten Feldverlauf eines Paars von Planarspulen im Vergleich mit einem Paar von Zylinderspulen in Helmholtz-Konfiguration, und
- Fig. 6: experimentelle Ergebnisse eines Vergleichs von Planarspulen mit Zylinderspulen, die außerhalb des Luftspalts um den Magnetkern des magnetischen Kreises gewickelt sind,

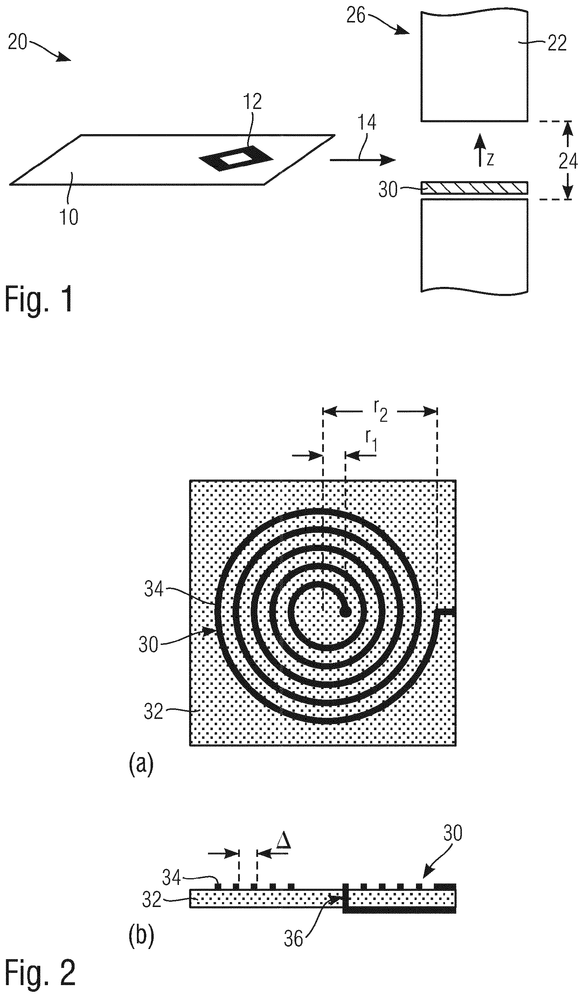

Die Erfindung wird nun am Beispiel der Echtheitsprüfung einer Banknote 10 erläutert. Figur 1 zeigt dazu schematisch eine Prüfvorrichtung 20 eines Banknotenbearbeitungssystems, von der in der Figur nur der für die vorliegende Erfindung besonders relevante Teilbereich des Sensorelements 26 dargestellt ist.

Der Banknotenprüfling 10 enthält in einem Merkmalsbereich ein zu prüfendes Spinresonanz-Merkmal 12, dessen charakteristische Eigenschaften zum Nachweis der Echtheit der Banknote dienen. Der Prüfling wird entlang eines Transportpfads 14 durch die Prüfvorrichtung 20, konkret durch den Luftspalt 24 eines magnetischen Kreises mit einem Magnetkern 22, geführt.

Der Luftspalt 24 erstreckt sich in einer Axialrichtung zwischen den an den Luftspalt angrenzenden Flächen des Magnetkerns 22. Die Axialrichtung des Luftspalts wird auch als z-Achse bezeichnet, die dazu senkrechten Richtungen definieren eine x-y-Ebene. In der x-y-Ebene kann der Magnetkern 22 beispielsweise rund, elliptisch, quadratisch, rechteckig, oder polygonal ausgebildet sein. Wie oben erläutert, werden im Luftspalt 24 zur Detektion von Signaturen des Spinresonanz-Merkmals 12 drei verschiedene Magnetfelder erzeugt, nämlich ein quasistatisches Polarisationsfeld B₀ parallel zur z-Achse, ein Modulationsfeld B_{mod}, ebenfalls parallel zur z-Achse, und ein dazu senkrechtes Anregefeld B₁, das die Energieübergänge zwischen den Spin-Energieniveaus im Spinresonanz-Merkmal 12 induziert.

Zur Erzeugung des Polarisationsfeldes B₀ kommt im Ausführungsbeispiel ein magnetischer Kreis mit dem Magnetkern 22 zum Einsatz, der den magnetischen Fluss eines Permanentmagneten und/ oder einer Spule zu dem Luftspalt 24 leitet. Als Besonderheit wird für die Erzeugung des Modulationsfelds B_{mod} eine in dem Luftspalt 24 angeordnete Planarspule 30 eingesetzt, die in der x-y-Ebene mehrere Windungen um die z-Achse aufweist.

Das Anregefeld B₁ wird mit Hilfe eines Resonators erzeugt, der der Übersichtlichkeit halber in Fig. 1 weggelassen ist.

Die Planarspule 30 ist in Fig. 2(a) in Aufsicht und in Fig. 2(b) im Querschnitt genauer dargestellt. Im Gegensatz zu einer Zylinderspule gleicher Windungszahl kann die Planarspule 30 mit ausreichend hoher Windungszahl ohne Weiteres in einem schmalen Luftspalt 24 platziert werden. Aufgrund der Anordnung der Planarspule 30 im Luftspalt 24 wird die Induktion von Wirbelströmen im Magnetkern 22 mit den oben beschriebenen Nachteilen unterdrückt. Darüber hinaus ist das von der Planarspule 30 erzeugte Modulationsfeld aufgrund seiner Geometrie für den Banknotenprüfling 10 sehr gut zugänglich.

Die Planarspule 30 ist auf einer Leiterplatte 32 aufgebaut und weist eine spiralförmige Führung der Leiterbahnen 34 zwischen einem minimalen Innenradius r₁ und einem maximalen Außenradius r₂ auf. Die Planarspule 30 hat im Ausführungsbeispiel fünf Windungen mit einem konstanten Leiterbahnabstand Δ. Im mittleren Bereich der Planarspule 30 ist eine Durchkontaktierung 36 zum Rückführen des Leiters vorgesehen.

Wie oben bereits grundsätzlich erläutert, bietet die Ausbildung der Planarspule 30 auf einer Leiterplatte mehrere Vorteile. Neben einer reproduzierbaren und kostengünstigen Fertigung kann auch der Resonator für das Anregefeld B₁ auf einer Leiterplatte ausgebildet werden, so dass die Planarspule 30 (oder mehrere Planarspulen) und der Resonator kompakt in verschiedenen Platinenebenen desselben Bauteils implementiert werden können.

Die Planarspule 30 kann allerdings auch auf anderen, beispielsweise ferromagnetischen, Trägern montiert werden, und auch eine Planarspule mit freiliegenden Wicklungen kommt in Betracht.

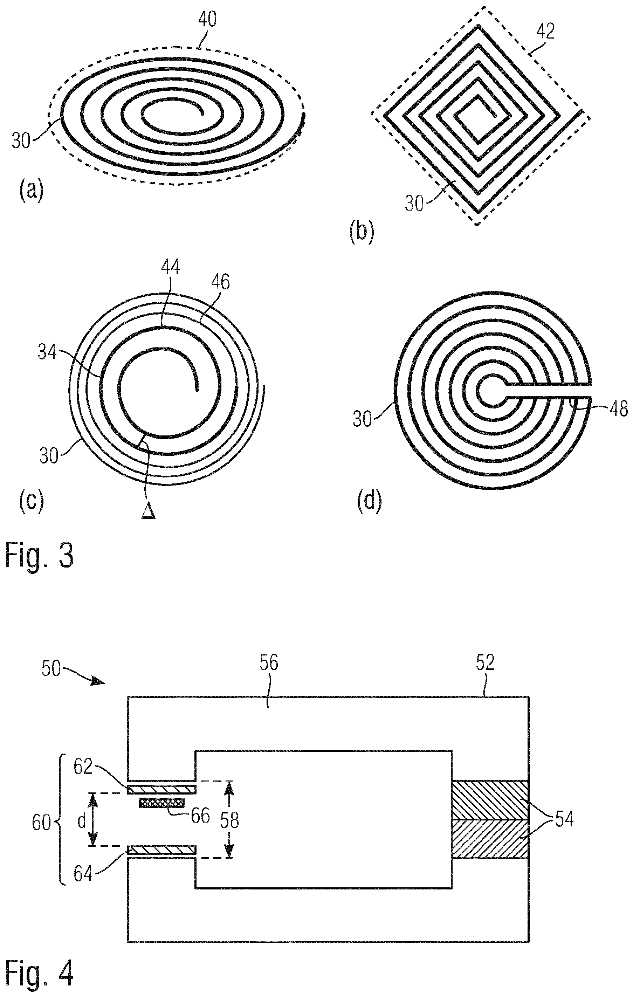

Bei der Geometrie der Planarspulen können neben der in Fig. 2 gezeigten spiralförmigen Leiterbahnführung mit kreisförmiger Außenkontur auch andere Geometrien mit Vorteil eingesetzt werden. Figur 3 zeigt in (a) bis (d) einige weitere vorteilhafte Ausführungsformen, wobei der Übersichtlichkeit halber jeweils nur die Planarspule selbst ohne Spulenträger dargestellt ist.

Konkret weist die Planarspule 30 der Fig. 3(a) eine spiralförmige Leiterbahnführung mit elliptischer Außenkontur 40 auf und die Planarspule 30 der Fig. 3(b) eine spiralförmige Leiterbahnführung mit rechteckiger Außenkontur 42. Auch andere polygonale Außenkonturen, beispielsweise dreieckig, fünf-, sechs- oder achteckig, kommen in Betracht.

Eine solche Variation der Außenkonturen ist vorteilhaft, um die räumliche B_{mod}-Verteilung an die Verteilung des Polarisationsfeldes B₀ anpassen zu können. Dadurch kann eine gleichartige B₀- und B_{mod}-Verteilung im Luftspalt erreicht werden, und somit die Entstehung von Signalartefakten unterdrückt werden.

Das Ausführungsbeispiel der Figur 3(c) illustriert, dass der Abstand Δ aufeinanderfolgender Windungen und die Breite der Leiterbahnen nicht konstant sein müssen. Bei der Planarspule 30 der Fig. 3(c) nimmt beispielsweise der Abstand Δ von innen nach außen streng monoton ab und die Leiterbahnen 34 sind im inneren Teil 44 der Spule mit einer größeren Breite als im äußeren Teil 46 der Spule ausgebildet. Variationen des Leiterbahnabstands Δ und der Leiterbahnbreite ermöglichen es, die Feldverteilung der Planarspule 30 im Luftspalt 24 besonders homogen zu gestalten. So hat das durch eine Planarspule erzeugte B_{mod}-Feld sein Maximum auf der Spulenachse. Mit zunehmendem radialen Abstand von der Spulenachse fällt das Feld ab. Über eine Erhöhung der Windungszahl im Außenbereich der Spule kann dieser Feldabfall kompensiert und die Feldverteilung in radialer Richtung homogenisiert werden. Bei einer gleichzeitigen Verringerung der Leiterbahnbreite im Außenbereich der Spule kann die Windungsdichte zusätzlich gesteigert werden. Es versteht sich, dass die im Zusammenhang mit Fig. 3(c) beschriebenen Variationen mit allen Geometrien der Planarspulen kombiniert werden können.

Bei geeigneter Ausbildung der Leiterbahnen 34 kann auch auf eine Durchkontaktierung zur Leiterbahnrückführung verzichtet werden. Das Ausführungsbeispiel der Fig. 3(d) illustriert eine Planarspule 30, bei der die Windungen kreisförmig mit jeweils konstantem Radius ausgebildet sind und bei der die Leiterbahnrückführung 48 in derselben Ebene wie die Windungen der Planarspule angeordnet ist, so dass keine Durchkontaktierung erforderlich ist. Damit kann die Spule vorteilhaft auf einer einzelnen Platinen-Ebene realisiert werden. Auch diese Gestaltung kann selbstverständlich anstelle der kreisförmigen Geometrie eine andere Geometrie der Außenkontur aufweisen und es können Variationen von Leiterbahnabstand und Leiterbahnbreite vorgesehen sein.

Eine im Luftspalt 24 des Magnetkerns angeordnete Planarspule 30 weist besonders vorteilhaft zwischen 10 und 30 Windungen auf, da sich gezeigt hat, dass mit solchen Windungszahlen bei typischen Leiterbahnabmessungen sowohl die Stärke als auch die Verteilung des Modulationsfelds im Luftspalt 24 optimiert werden können. Wie aus Fig. 1 ersichtlich, wird aufgrund der planaren Bauform der Spule 30 nur ein Minimum an Bauraum im Luftspalt verbraucht, so dass der Luftspalt für ein hohes Modulationsfeld B_{mod} nicht unnötig vergrößert und dadurch die Feldstärke des Polarisationsfelds B₀ reduziert werden muss.

Figur 4 zeigt ein weiteres Ausführungsbeispiel eines erfindungsgemäßen Sensorelements 50, bei dem im Luftspalt ein Planarspulen-Paar vorgesehen ist. Konkret enthält das Sensorelement 50 einen Polarisationsmagneten 52 mit Magnetrückschluss mit einem Permanentmagneten 54 und einem Magnetkern 56 mit einem Luftspalt 58, durch welchen der Transportpfad der Banknotenprüflinge verläuft.

Im Luftspalt 58 ist neben einem Resonator 66 zur Erzeugung des Anregefelds B₁ eine Modulationseinrichtung 60 zur Erzeugung des magnetischen Modulationsfelds B_{mod} angeordnet, welche im Ausführungsbeispiel aus einem Paar von Planarspulen 62, 64 besteht, die axial beabstandet an der Ober- bzw. Unterseite des Luftspalts 58 angeordnet sind. Dabei sind der minimale Innenradius r₁ und der maximale Außenradius r₂ der Leiterbahnführung der Planarspulen 62, 64 so auf den axialen Spulenabstand abgestimmt, dass ein möglichst homogener Feldverlauf im Luftspalt zwischen den beiden Planarspulen 62, 64 entsteht. Hierzu kann der axiale Abstand der Spulen beispielsweise das Doppelte des Innenradius r₁ der beiden Spulen betragen.

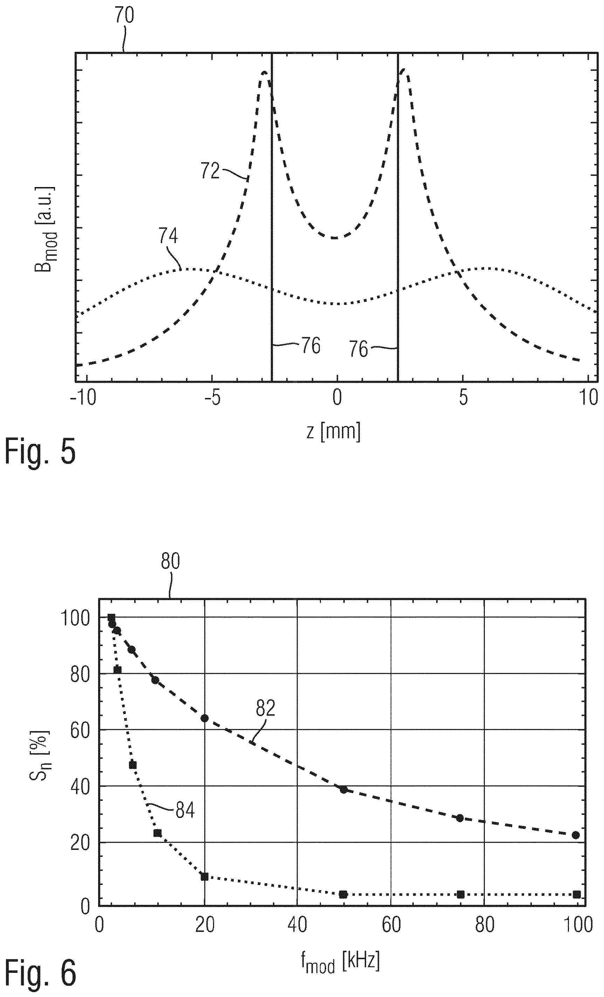

Figuren 5 und 6 illustrieren anhand von Vergleichsberechnungen bzw. Vergleichsversuchen die überlegenen Eigenschaften erfindungsgemäßer Modulationseinrichtungen mit Planarspulen gegenüber Gestaltungen mit herkömmlichen Zylinderspulen.

Zunächst zeigt das Diagramm 70 der Fig. 5 den analytisch berechneten Feldverlauf eines Paars von Planarspulen (Kurve 72) im Vergleich mit einem entsprechenden Paar von Zylinderspulen in Helmholtz-Konfiguration (Kurve 74). Die vertikalen Linien markieren den Bereich des frei zugänglichen Luftspalts 76.

Für die Berechnung wurde angenommen, dass zwischen dem jeweiligen Spulenpaar ein unverbauter Abstand von d = 5 mm (Fig. 4) für den Transportpfad der Banknotenprüflinge 10 zur Verfügung steht. Weiter wurde angenommen, dass jede Einzelspule zehn Windungen aufweist und mit einer Leiterbahn einer Breite von 0,5 mm realisiert ist. Der Abstand aufeinanderfolgender Windungen beträgt jeweils 0,25 mm. Für den Innenradius r₁ der Planarspulen wurde ein Wert von r₁ = 0,375 mm angenommen, der Einfluss der jeweiligen Spulenträger wurde vernachlässigt. Mit diesen Annahmen ergibt sich für die beiden Zylinderspulen eine Länge von 7,25 mm, für die beiden Planarspulen ergibt sich ein äußerer Radius r₂ von ebenfalls 7,25 mm.

Das Diagramm 70 zeigt die mit diesen Annahmen berechnete Feldstärke B_{mod} in z-Richtung als Funktion der axialen Ortskoordinate z. Eingezeichnet ist auch der relevante Teil des Luftspaltes zwischen den Linien 76 bei den Werten z = ± 2,5 mm entsprechend d = 5 mm. Wie aus dem Diagramm unmittelbar ersichtlich, erzeugt das erfindungsgemäße Planarspulen-Paar (Kurve 72) im Luftspalt ein Modulationsfeld B_{mod} einer wesentlich höheren Feldstärke als das herkömmliche Zylinderspulen-Paar (Kurve 74).

Neben der Erzeugung eines höheren Modulationsfelds benötigt das erfindungsgemäße Planarspulen-Paar auch deutlich weniger Bauraum im Luftspalt als das entsprechende Zylinderspulen-Paar. So haben die beiden Planarspulen zusammengenommen eine axiale Ausdehnung in z-Richtung von nur 1 mm, während die beiden Zylinder-Spulen zusammengenommen eine z-Ausdehnung von 14,5 mm aufweisen. Bei Berücksichtigung des benötigten unverbauten Spaltbereichs einer Höhe von d = 5 mm für den Banknotentransport, muss der magnetische Kreis bei Verwendung eines Zylinder-Spulenpaares somit einen Luftspalt einer Höhe von mindestens 19,5 mm aufweisen. Im Gegensatz dazu genügt bei der Verwendung des erfindungsgemäßen Planarspulen-Paars ein Luftspalt einer Höhe von nur 6 mm. Mit diesem schmäleren Luftspalt ist ein wesentlich stärkeres quasistatisches Polarisationsfeld B₀ verbunden, so dass auch aus diesem Grund eine deutlich höhere Signalstärke bei der Spinresonanz-Messung erreicht werden kann.

Das Diagramm 80 der Fig. 6 enthält experimentelle Ergebnisse eines Vergleichs erfindungsgemäßer Planarspulen im Luftspalt mit herkömmlichen Zylinderspulen, die außerhalb des Luftspalts um den Magnetkern eines magnetischen Kreises gewickelt sind.

Für die Vergleichsmessung wurde eine Papierprobe mit einem Merkmalsstoff mit Spinresonanz-Signatur beladen und auf einen Streifenleitungsresonator aufgelegt. Der Resonator befand sich dabei innerhalb des Luftspalts eines magnetischen Kreises aus Weicheisen. Mit diesem Aufbau wurden zwei Messreihen durchgeführt.

In der ersten Messreihe wurde eine spiralförmige Planarspule 30 der in Fig. 2 gezeigten Art mit konstantem Abstand der Leiterbahnen als Modulationsspule verwendet. Die Planarspule 30 ist auf einer Leiterplatte implementiert und weist insgesamt 25 Windungen mit einem Innenradius r₁ = 0,375 mm und einem Außenradius r₂ = 7,25 mm auf. Die Gesamtdicke der so gefertigten Platine beträgt 0,75 mm. Die Planarspule 30 wurde direkt im Luftspalt des magnetischen Kreises befestigt und wies entlang der z-Achse einen Abstand von 2,8 mm zum Resonator auf.

In der zweiten Messreihe wurde eine herkömmliche Zylinderspule als Modulationsspule verwendet. Die Zylinderspule wurde mit einem Radius von 22,2 mm mit 72 Wicklungen um den Magnetkern des magnetischen Kreises an der Kante zum Luftspalt gewickelt. Der Abstand entlang der z-Achse zwischen Spulenmitte und Streifenleitungsresonator betrug 7,1 mm.

Innerhalb jeder Messreihe wurde bei unterschiedlichen Modulationsfrequenzen f_{mod} jeweils die Spinresonanz-Signatur des Markers aufgezeichnet und das Signalmaximum jeder Messung extrahiert. Zur besseren Vergleichbarkeit wurden die so erhaltenen Messewerte auf das Gesamtmaximum beider Messreihen normiert, um eine normierte Signalstärke Sₙ zu erhalten. Diese normierte Signalstärke Sₙ ist im Diagramm 80 jeweils als Funktion der Modulationsfrequenz f_{mod} aufgetragen und zeigt die Frequenzabhängigkeit der Signalstärke bei Verwendung einer erfindungsgemäßen Planarspule (Kurve 82) bzw. bei Verwendung einer herkömmlichen Zylinderspule (Kurve 84).

Wie aus dem Diagramm 80 ersichtlich, fällt die Signalstärke des Spinresonanz-Signals für beide Gestaltungen mit steigender Modulationsfrequenz f_{mod} ab. Ursache hierfür sind nach gegenwärtigem Verständnis vorrangig Wirbelströme, die vom Modulationsfeld B_{mod} im Weicheisen des magnetischen Kreises induziert werden und nach der Lenzschen Regel das erzeugende Modulationsfeld schwächen. Aufgrund ihrer Größe und Position induziert die Zylinderspule allerdings in einem wesentlich stärkeren Ausmaß Wirbelströme als die erfindungsgemäße Planarspule im Luftspalt. Aus diesem Grund fällt die Signalstärke Sₙ für die Zylinderspule (Kurve 84) mit steigender Modulationsfrequenz f_{mod} wesentlich schneller ab als für die erfindungsgemäße Planarspule (Kurve 82). Ein Spinresonanz-Sensorelement für den Einsatz in einer schnell laufenden Banknotenbearbeitungsmaschine benötigt hohe Modulationsfrequenzen, um Bewegungsartefakte zu reduzieren bzw. zu vermeiden.

Bei einer solchen hohen Modulationsfrequenz ist der Betrieb einer um den Magnetkern gewickelten Zylinderspule aufgrund der Wirbelströme ineffizient und ermöglicht keine ausreichend hohe Signalstärke des Spinresonanz-Signals für eine zuverlässige Echtheitsprüfung.

### Bezugszeichenliste

- 10: Banknotenprüfling
- 12: Spinresonanz-Merkmal
- 14: Transportpfad
- 20: Prüfvorrichtung
- 22: Magnetkern
- 24: Luftspalt
- 30: Planarspule
- 32: Leiterplatte
- 34: Leiterbahnen
- 36: Durchkontaktierung
- 40: elliptische Außenkontur
- 42: rechteckige Außenkontur
- 44: innerer Spulenteil
- 46: äußerer Spulenteil
- 48: Leiterbahnrückführung
- 50: Sensorelement
- 52: Polarisationsmagnet
- 54: Permanentmagnet
- 56: Magnetkern
- 58: Luftspalt
- 60: Modulationseinrichtung
- 62, 64: Planarspulen
- 66: Resonator
- 70: Diagramm
- 72: Feldverlauf eines Paars von Planarspulen
- 74: Feldverlauf eines Paars von Zylinderspulen
- 80: Diagramm
- 82: Frequenzabhängigkeit Planarspule
- 84: Frequenzabhängigkeit Zylinderspule

## Patentansprüche

1. Sensorelement (26) für die Prüfung eines flächigen Datenträgers (10), insbesondere einer Banknote, mit einem Spinresonanz-Merkmal (12), mit
- einem Magnetkern (22) mit einem Luftspalt (24), in den der flächige Datenträger (10) zur Echtheitsprüfung einbringbar ist, und der eine sich zwischen den angrenzenden Flächen des Magnetkerns (22) erstreckende Axialrichtung definiert,
- einer Polarisationseinrichtung zu Erzeugung eines statischen magnetischen Flusses in dem Luftspalt (24),
- einer Modulationseinrichtung (30) zur Erzeugung eines zeitlich variierenden magnetischen Modulationsfelds in dem Luftspalt (24), und
- einem Resonator zur Anregung des Spinresonanz-Merkmals (12) des zu prüfenden Datenträgers (10),
**dadurch gekennzeichnet, dass**
- die Modulationseinrichtung durch zumindest eine in dem Luftspalt angeordnete Planarspule (30) gebildet ist, die in einer Ebene eine oder mehrere Windungen um die Axialrichtung des Luftspalts aufweist.

2. Sensorelement (26) nach Anspruch 1, **dadurch gekennzeichnet, dass** die zumindest eine Planarspule (30) eine spiralförmige Leiterbahnführung mit einem minimalen Innenradius (r₁) und einem maximalen Außenradius (r₂) aufweist.

3. Sensorelement (26) nach Anspruch 1 oder 2, **dadurch gekennzeichnet, dass** die Außenkontur (40, 42) der Leiterbahnführung der zumindest einen Planarspule (30) kreisförmig, elliptisch, rechteckig oder polygonal ist.

4. Sensorelement (26) nach wenigstens einem der Ansprüche 1 bis 3, **dadurch gekennzeichnet, dass** der Leiterbahnabstand (Δ) aufeinanderfolgender Windungen konstant ist.

5. Sensorelement (26) nach wenigstens einem der Ansprüche 1 bis 4, **dadurch gekennzeichnet, dass** die Windungszahl der zumindest einen Planarspule (30) zwischen 2 und 100 (je einschließlich), bevorzugt zwischen 10 und 30 (je einschließlich) liegt.

6. Sensorelement (26) nach wenigstens einem der Ansprüche 1 bis 5, **dadurch gekennzeichnet, dass** die Modulationseinrichtung (60) zwei Planarspulen (62, 64) enthält, die axial beabstandet an der Oberseite bzw. Unterseite des Luftspalts (58) angeordnet sind.

7. Sensorelement (26) nach Anspruch 6, **dadurch gekennzeichnet, dass** die zwei genannten Planarspulen (62, 64) so angeordnet und aufeinander abgestimmt sind, dass sie zwischen sich einen homogenen Feldverlauf des Modulationsfelds erzeugen, vorzugsweise, dass die zwei genannten Planarspulen jeweils mit einer Leiterbahnführung mit gleichem minimalen Innenradius und gleichem maximalen Außenradius ausgebildet sind und in axialer Richtung einen Abstand aufweisen, der im Wesentlichen dem doppelten Innenradius entspricht.

8. Sensorelement (26) nach wenigstens einem der Ansprüche 1 bis 7, **dadurch gekennzeichnet, dass** die zumindest eine Planarspule (30) auf einem Spulenträger, insbesondere einer Leiterplatte (32), oder auf einem ferromagnetischen Träger ausbildet ist.

9. Sensorelement (26) nach wenigstens einem der Ansprüche 1 bis 8, **dadurch gekennzeichnet, dass** die zumindest eine Planarspule (30) zusammen mit einer Kapazität einen resonanten Schwingkreis bildet.

10. Sensorelement (26) nach wenigstens einem der Ansprüche 1 bis 9, **dadurch gekennzeichnet, dass** die Modulationseinrichtung zumindest eine Doppel-Planarspule umfasst, bei der auf der Ober- und Unterseite eines Spulenträgers koaxial jeweils die Windungen einer Planarspule angeordnet sind.

11. Sensorelement (26) nach wenigstens einem der Ansprüche 1 bis 10, **dadurch gekennzeichnet, dass** der Resonator auf einer Leiterplatte ausgebildet ist, vorzugsweise in Form eines planaren Oberflächenresonators, insbesondere eines Streifenleitungsresonators, und zusammen mit der zumindest einen Planarspule auf unterschiedlichen Leiterplattenebenen desselben Bauelements angeordnet ist.

12. Prüfvorrichtung (20) für die Prüfung flächiger Datenträger, insbesondere Banknoten, mit einem Sensorelement (26) nach einem der Ansprüche 1 bis 11 und mit einer Transporteinrichtung, die die zu prüfenden flächigen Datenträger entlang eines Transportpfades in den Luftspalt des Magnetkerns einbringt bzw. durch den Luftspalt des Magnetkerns hindurchführt.

13. Verfahren zur Prüfung eines flächigen Datenträgers, insbesondere einer Banknote, mit einem Spinresonanz-Merkmal (12) mittels eines Sensorelements (26) nach einem der Ansprüche 1 bis 11, wobei bei dem Verfahren
- ein zu prüfender flächiger Datenträger in den Luftspalt (24) des Magnetkerns (22) des genannten Sensorelements (26) eingebracht wird,
- mit der Polarisationseinrichtung ein statischer magnetischer Fluss in dem Luftspalt (24) erzeugt wird,
- mit der Modulationseinrichtung (30) ein zeitlich variierendes magnetisches Modulationsfeld in dem Luftspalt (24) erzeugt wird, wobei als Modulationseinrichtung eine Einrichtung vorgesehen wird, die durch zumindest eine in dem Luftspalt angeordnete Planarspule (30) gebildet ist, die in einer Ebene eine oder mehrere Windungen um die Axialrichtung des Luftspalts aufweist, und
- mit dem Resonator das Spinresonanz-Merkmal (12) des zu prüfenden Datenträgers (10) angeregt wird,

14. Verfahren nach Anspruch 13, **dadurch gekennzeichnet, dass** mit dem Resonator auch ein durch die Anregung erzeugtes Antwortsignal des Spinresonanz-Merkmals (12) aufgenommen und an einen Detektor ausgegeben wird.

15. Verfahren nach Anspruch 13 oder 14, **dadurch gekennzeichnet, dass** die Anregung des Spinresonanz-Merkmals (12) und/oder die Aufnahme des Antwortsignals des Spinresonanz-Merkmals (12) in einem Dauerstrich (CW)-Verfahren, in einem gepulsten Verfahren oder in einem Rapid-Scan-Verfahren erfolgt.

## Claims

1. Sensor element (26) for the checking of a planar data carrier (10), in particular a banknote, with a spin resonance feature (12), with
- a magnetic core (22) with an air gap (24), into which the planar data carrier (10) can be introduced for authenticity checking, and which defines an axial direction extending between the adjacent surfaces of the magnetic core (22),
- a polarization device for generating a static magnetic flux in the air gap (24),
- a modulation device (30) for generating a time-varying magnetic modulation field in the air gap (24), and
- a resonator for the excitation of the spin resonance feature (12) of the data carrier (10) to be checked,
**characterized in that**
- the modulation device is formed by at least one planar coil (30) arranged in the air gap, which in one plane has one or more turns around the axial direction of the air gap.

2. Sensor element (26) according to claim 1, **characterized in that** the at least one planar coil (30) has a spiral conductor track routing with a minimum inner radius (r1) and a maximum outer radius (r2).

3. Sensor element (26) according to claim 1 or 2, **characterized in that** the outer contour (40, 42) of the conductor track routing of the at least one planar coil (30) is circular, elliptical, rectangular or polygonal.

4. Sensor element (26) according to at least one of claims 1 to 3, **characterized in that** the conductor track spacing (Δ) of successive turns is constant.

5. Sensor element (26) according to at least one of claims 1 to 4, **characterized in that** the number of turns of the at least one planar coil (30) lies between 2 and 100 (inclusive in each case), preferably between 10 and 30 (inclusive in each case).

6. Sensor element (26) according to at least one of claims 1 to 5, **characterized in that** the modulation device (60) contains two planar coils (62, 64) which are arranged axially spaced on the top side and bottom side, respectively, of the air gap (58).

7. Sensor element (26) according to claim 6, **characterized in that** the two said planar coils (62, 64) are arranged and matched to one another such that they generate a homogeneous field profile of the modulation field between them, preferably, that the two said planar coils are each formed with a conductor track routing with the same minimum inner radius and the same maximum outer radius and have a spacing in the axial direction which essentially corresponds to twice the inner radius.

8. Sensor element (26) according to at least one of claims 1 to 7, **characterized in that** the at least one planar coil (30) is formed on a coil carrier, in particular a printed circuit board (32), or on a ferromagnetic carrier.

9. Sensor element (26) according to at least one of claims 1 to 8, **characterized in that** the at least one planar coil (30) forms a resonant circuit together with a capacitance.

10. Sensor element (26) according to at least one of claims 1 to 9, **characterized in that** the modulation device comprises at least one double planar coil, in which on the top side and bottom side of a coil carrier the turns of a respective planar coil are arranged coaxially.

11. Sensor element (26) according to at least one of claims 1 to 10, **characterized in that** the resonator is formed on a printed circuit board, preferably in the form of a planar surface resonator, in particular a stripline resonator, and is arranged together with the at least one planar coil on different printed circuit board layers of the same component.

12. Checking device (20) for the checking of planar data carriers, in particular banknotes, with a sensor element (26) according to any of claims 1 to 11 and with a transport device which introduces the planar data carriers to be checked along a transport path into the air gap of the magnetic core or guides them through the air gap of the magnetic core.

13. Method for the checking of a planar data carrier, in particular a banknote, with a spin resonance feature (12) by means of a sensor element (26) according to any of claims 1 to 11, wherein in the method
- a planar data carrier to be checked is introduced into the air gap (24) of the magnetic core (22) of the said sensor element (26),
- with the polarization device a static magnetic flux is generated in the air gap (24),
- with the modulation device (30) a time-varying magnetic modulation field is generated in the air gap (24), wherein as the modulation device a device is provided which is formed by at least one planar coil (30) arranged in the air gap, which in one plane has one or more turns around the axial direction of the air gap, and
- with the resonator the spin resonance feature (12) of the data carrier (10) to be checked is excited,

14. Method according to claim 13, **characterized in that** with the resonator there is also recorded a response signal of the spin resonance feature (12) generated by the excitation and output to a detector.

15. Method according to claim 13 or 14, **characterized in that** the excitation of the spin resonance feature (12) and/or the recording of the response signal of the spin resonance feature (12) is carried out in a continuous-wave (CW) method, in a pulsed method, or in a rapid-scan method.

## Revendications

1. Élément de capteur (26) pour la vérification d'un support de données planaire (10), en particulier d'un billet de banque, avec une caractéristique de résonance de spin (12), avec
- un noyau magnétique (22) avec un entrefer (24), dans lequel le support de données planaire (10) peut être introduit pour la vérification d'authenticité, et qui définit une direction axiale s'étendant entre les surfaces adjacentes du noyau magnétique (22),
- un dispositif de polarisation pour la génération d'un flux magnétique statique dans l'entrefer (24),
- un dispositif de modulation (30) pour la génération d'un champ de modulation magnétique variant dans le temps dans l'entrefer (24), et
- un résonateur pour l'excitation de la caractéristique de résonance de spin (12) du support de données (10) à vérifier,
**caractérisé en ce que**
- le dispositif de modulation est formé par au moins une bobine planaire (30) disposée dans l'entrefer, qui présente dans un plan une ou plusieurs spires autour de la direction axiale de l'entrefer.

2. Élément de capteur (26) selon la revendication 1, **caractérisé en ce que** la bobine planaire (30) au moins présente un agencement de piste conductrice en spirale avec un rayon intérieur minimal (r1) et un rayon extérieur maximal (r2).

3. Élément de capteur (26) selon la revendication 1 ou 2, **caractérisé en ce que** le contour extérieur (40, 42) de l'agencement de piste conductrice de la bobine planaire (30) au moins est circulaire, elliptique, rectangulaire ou polygonal.

4. Élément de capteur (26) selon au moins une des revendications 1 à 3, **caractérisé en ce que** l'espacement des pistes conductrices (Δ) de spires successives est constant.

5. Élément de capteur (26) selon au moins une des revendications 1 à 4, **caractérisé en ce que** le nombre de spires de la bobine planaire (30) au moins est compris entre 2 et 100 (dans chaque cas inclus), de préférence entre 10 et 30 (dans chaque cas inclus).

6. Élément de capteur (26) selon au moins une des revendications 1 à 5, **caractérisé en ce que** le dispositif de modulation (60) contient deux bobines planaires (62, 64) qui sont espacées axialement et disposées sur la face supérieure et la face inférieure, respectivement, de l'entrefer (58).

7. Élément de capteur (26) selon la revendication 6, **caractérisé en ce que** les deux bobines planaires susdites (62, 64) sont disposées et accordées l'une à l'autre de manière à générer entre elles un profil de champ homogène du champ de modulation, de préférence, **en ce que** les deux bobines planaires susdites sont chacune réalisées avec un agencement de piste conductrice avec le même rayon intérieur minimal et le même rayon extérieur maximal et présentent dans la direction axiale un espacement qui correspond essentiellement au double du rayon intérieur.

8. Élément de capteur (26) selon au moins une des revendications 1 à 7, **caractérisé en ce que** la bobine planaire (30) au moins est réalisée sur un support de bobine, en particulier une carte de circuit imprimé (32), ou sur un support ferromagnétique.

9. Élément de capteur (26) selon au moins une des revendications 1 à 8, **caractérisé en ce que** la bobine planaire (30) au moins forme un circuit résonant avec une capacité.

10. Élément de capteur (26) selon au moins une des revendications 1 à 9, **caractérisé en ce que** le dispositif de modulation comprend au moins une bobine planaire double, dans laquelle sur la face supérieure et la face inférieure d'un support de bobine sont disposées coaxialement respectivement les spires d'une bobine planaire.

11. Élément de capteur (26) selon au moins une des revendications 1 à 10, **caractérisé en ce que** le résonateur est réalisé sur une carte de circuit imprimé, de préférence sous la forme d'un résonateur de surface planaire, en particulier d'un résonateur à ligne ruban, et est disposé avec la bobine planaire (30) au moins sur des couches de carte de circuit imprimé différentes du même composant.

12. Dispositif de vérification (20) pour la vérification de supports de données planaires, en particulier de billets de banque, avec un élément de capteur (26) selon l'une quelconque des revendications 1 à 11 et avec un dispositif de transport qui introduit les supports de données planaires à vérifier le long d'un trajet de transport dans l'entrefer du noyau magnétique ou les guide à travers l'entrefer du noyau magnétique.

13. Procédé pour la vérification d'un support de données planaire, en particulier d'un billet de banque, avec une caractéristique de résonance de spin (12) au moyen d'un élément de capteur (26) selon l'une quelconque des revendications 1 à 11, le procédé consistant en ce que
- un support de données planaire à vérifier est introduit dans l'entrefer (24) du noyau magnétique (22) dudit élément de capteur (26),
- avec le dispositif de polarisation un flux magnétique statique est généré dans l'entrefer (24),
- avec le dispositif de modulation (30) un champ de modulation magnétique variant dans le temps est généré dans l'entrefer (24), un dispositif étant prévu comme dispositif de modulation, lequel est formé par au moins une bobine planaire (30) disposée dans l'entrefer, qui présente dans un plan une ou plusieurs spires autour de la direction axiale de l'entrefer, et
- avec le résonateur la caractéristique de résonance de spin (12) du support de données (10) à vérifier est excitée,

14. Procédé selon la revendication 13, **caractérisé en ce que**, avec le résonateur, est également enregistré un signal de réponse de la caractéristique de résonance de spin (12) généré par l'excitation et délivré à un détecteur.

15. Procédé selon la revendication 13 ou 14, **caractérisé en ce que** l'excitation de la caractéristique de résonance de spin (12) et/ou l'enregistrement du signal de réponse de la caractéristique de résonance de spin (12) est effectué dans un procédé à onde continue (CW), dans un procédé pulsé ou dans un procédé à balayage rapide.
